# EUROPEAN PATENT APPLICATION

(11) **EP 4 610 683 A1**
(43) Date of publication of application: **03.09.2025**
(21) Application number: 25159038.6
(22) Date of filing: 20.02.2025
(51) Int. Cl.: G01R 33/00, G01R 33/09

(54) **MAGNETIC SENSOR**

(30) Priority: 21.02.2024 JP 2024024349
(71) Applicant: TDK Corporation, Tokyo 103-6128 (JP)
(72) Inventor: HARATANI, Susumu, Tokyo, 103-6128 (JP); ONODERA, Ikuhito, Tokyo, 103-6128 (JP)
(74) Representative: Epping - Hermann - Fischer

(57) **Abstract**

Disclosed herein is a magnetic sensor that includes a sensor chip having a magnetosensitive element, a magnetic field collecting body for collecting a magnetic field to the magnetosensitive element, an excitation coil wound around the magnetic field collecting body, and a modulation circuit that supplies an excitation current having a predetermined frequency to the excitation coil so as to periodically magnetically saturate the magnetosensitive element without magnetically saturating the magnetic field collecting body.

## Description

### BACKGROUND OF THE ART

### --Field of the Art

The present disclosure relates to a magnetic sensor and, more particularly, to a magnetic sensor capable of detecting a magnetic field in a low frequency region with high sensitivity.

### --Description of Related Art

Magnetic sensors using a magnetosensitive element are now in use in various fields. In order for magnetic sensors to detect an extremely weak magnetic field, they need to have a high S/N ratio. As a factor that reduces the S/N ratio of a magnetic sensor, 1/f noise can be cited. The 1/f noise becomes more conspicuous as the frequency component of a magnetic field to be measured becomes lower, so that it is important to reduce the 1/f noise for high-sensitivity detection of a magnetic field in a low frequency region of 1 kHz or less, for example.

JP-T-2020-522696 discloses a magnetic sensor having reduced 1/f noise. This magnetic sensor periodically saturates a magnetosensitive element using a modulator to reduce the 1/f noise.

However, the magnetic sensor described in JP-T-2020-522696 has a simple configuration in which a current line for saturating the magnetosensitive element is disposed near the magnetic sensor, posing a problem that it requires a large current to saturate a magnetosensitive element.

### SUMMARY

The present disclosure describes a technology for reducing, in a magnetic sensor capable of detecting a magnetic field in a low frequency region with high sensitivity, the amount of current required for modulation.

A magnetic sensor according to an aspect of the present disclosure includes: a sensor chip having a magnetosensitive element; a magnetic field collecting body for collecting a magnetic field to the magnetosensitive element; an excitation coil wound around the magnetic field collecting body; and a modulation circuit that supplies an excitation current having a predetermined frequency to the excitation coil so as to periodically magnetically saturate the magnetosensitive element without magnetically saturating the magnetic field collecting body.

According to the present disclosure, a technology for reducing, in a magnetic sensor capable of detecting a magnetic field in a low frequency region with high sensitivity, the amount of current required for modulation can be obtained.

### BRIEF DESCRIPTION OF THE DRAWINGS

The above features and advantages of the present disclosure will be more apparent from the following description of some embodiments taken in conjunction with the accompanying drawings, in which:
FIG. 1 is a schematic perspective view illustrating the outer appearance of a magnetic sensor 1 according to a first embodiment of the present disclosure;
FIG. 2 is a schematic perspective view of the sensor chip 100;
FIG. 3 is a schematic perspective view of the magnetic field collecting body 120;
FIG. 4 is a schematic plan view of the sensor chip 100;
FIG. 5 is a schematic cross-sectional view taken along the line A-A in FIG. 4;
FIG. 6 is a circuit diagram for explaining the connection relationship between the magnetosensitive elements R1 to R4;
FIG. 7 is a circuit diagram of a closed loop circuit including the magnetosensitive elements R1 to R4;
FIG. 8 is a schematic perspective view illustrating the outer appearance of a magnetic sensor 2 according to a second embodiment of the present disclosure; and
FIG. 9 is a schematic plan view illustrating the configuration of the main part of a magnetic sensor 3 according to a third embodiment of the present disclosure.

### DETAILED DESCRIPTION OF THE EMBODIMENTS

Some embodiments of the present disclosure will be explained below in detail with reference to the accompanying drawings.

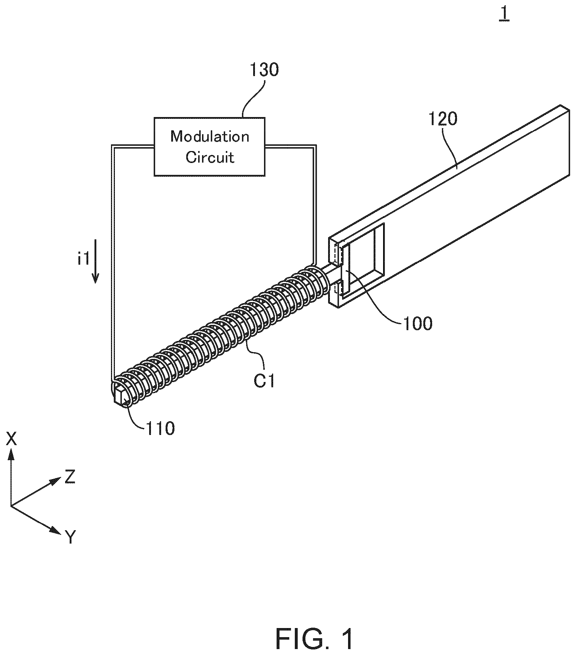

FIG. 1 is a schematic perspective view illustrating the outer appearance of a magnetic sensor 1 according to a first embodiment of the present disclosure.

As illustrated in FIG. 1, the magnetic sensor 1 according to the first embodiment includes a sensor chip 100 having a magnetosensitive element, magnetic field collecting bodies 110 and 120 for collecting a magnetic field to the magnetosensitive element provided in the sensor chip 100, and an excitation coil C1 wound around the magnetic field collecting body 110. The magnetic field collecting bodies 110 and 120 are each a block made of a high permeability material such as ferrite. The magnetic field collecting body 110 has a bar-like shape elongated in the Z-direction, and the end portion thereof in the positive Z-direction faces the sensor chip 100. The magnetic field collecting body 110 is wound with the excitation coil C1 having its axis extending in the Z-direction.

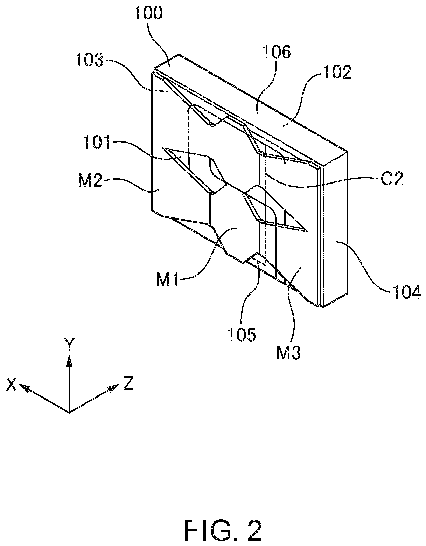

FIG. 2 is a schematic perspective view of the sensor chip 100.

As illustrated in FIG. 2, the sensor chip 100 has an element formation surface 101, a back surface 102, and side surfaces 103, 104, 105, and 106. The element formation surface 101 and back surface 102 constitute the XY surface and are positioned on the mutually opposite sides. The side surfaces 103 and 104 constitute the YZ surface and positioned on the mutually opposite sides. The side surfaces 105 and 106 constitute the XZ surface and are positioned on the mutually opposite sides. There are formed, on the element formation surface 101 of the sensor chip 100, magnetosensitive elements (to be described later) and magnetic layers M1 to M3 (to be described later).

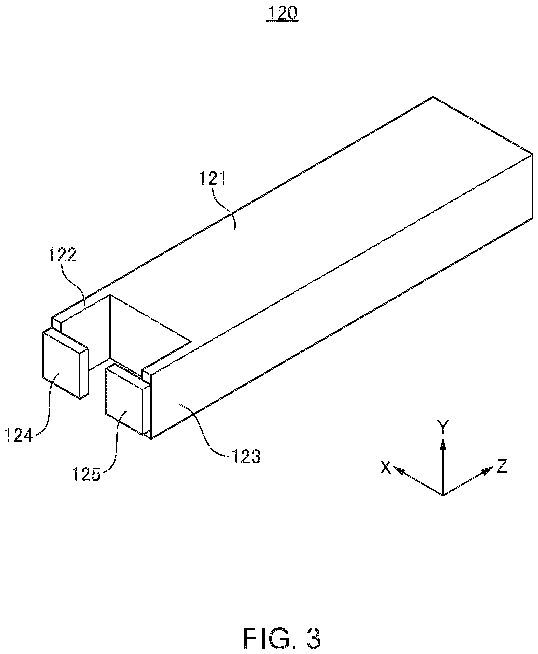

FIG. 3 is a schematic perspective view of the magnetic field collecting body 120.

As illustrated in FIG. 3, the magnetic field collecting body 120 has a main body part 121 elongated in the Z-direction, a pair of protruding parts 122 and 123 protruding, in the negative Z-direction, from the negative Z-direction end portion of the main body part 121 and having a thickness in the X-direction smaller than that of the main body part 121, an overhung part 124 protruding, in the negative X-direction, from the negative Z-direction end portion of the protruding part 122, and an overhung part 125 protruding, in the positive X-direction, from the negative Z-direction end portion of the protruding part 123. The sensor chip 100 is disposed in a space surrounded by the main body part 121, protruding parts 122 and 123, and overhung parts 124 and 125.

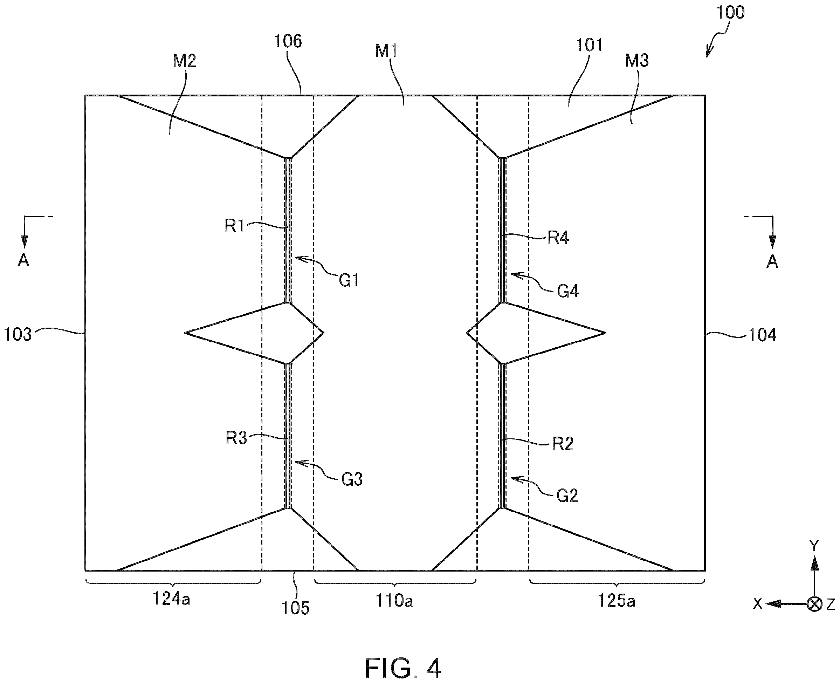

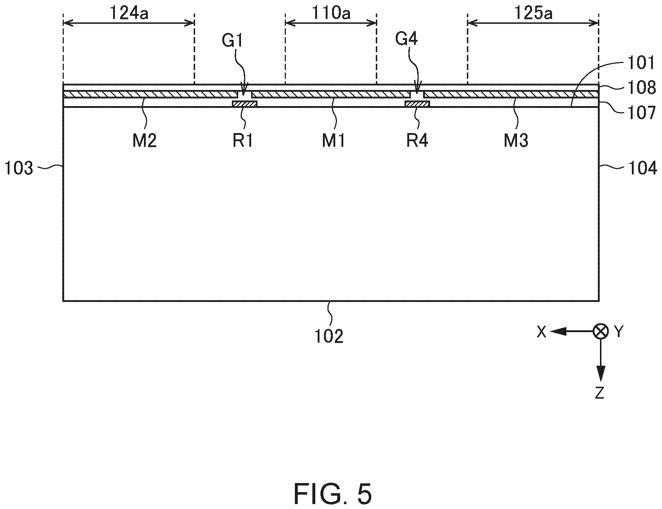

FIG. 4 is a schematic plan view of the sensor chip 100, and FIG. 5 is a schematic cross-sectional view taken along the line A-A in FIG. 4.

As illustrated in FIGS. 4 and 5, four magnetosensitive elements R1 to R4 are formed on the element formation surface 101 of the sensor chip 100. The magnetosensitive elements R1 to R4 are not particularly limited in type as long as they are elements whose electric resistance varies depending on the direction of magnetic flux and may be, for example, an MR element. The fixed magnetization directions of the magnetosensitive elements R1 to R4 are the same direction (for example, positive side in the X-direction). The magnetosensitive elements R1 to R4 are covered with an insulating layer 107, on the surface of which magnetic layers M1 to M3 made of permalloy or the like are formed. The magnetic layers M1 to M3 are covered with an insulating layer 108. The magnetic layer M1 is disposed at substantially the center of the element formation surface 101 in the X-direction. The magnetic layers M2 and M3 are disposed at both sides of the element formation surface 101 in the X-direction so as to sandwich the magnetic layer M1 in the X-direction.

The magnetic layers M1 and M2 form two gaps G1 and G3 each having a width in the X-direction and extending in the Y-direction. The gaps G1 and G3 are at the same X-direction position and arranged in the Y-direction. The magnetic layers M1 and M3 form two gaps G2 and G4 having a width in the X-direction and extending in the Y-direction. The gaps G2 and G4 are at the same X-direction position and arranged in the Y-direction. The gaps G1 and G4 are arranged in the X-direction, and the gaps G2 and G3 are arranged in the X-direction. The magnetosensitive elements R1 to R4 are disposed at positions overlapping the gaps G1 to G4, respectively, in a plan view (as viewed in the Z-direction). With this configuration, magnetic fields in the X-direction passing through respective magnetic gaps G1 to G4 are applied respectively to the magnetosensitive elements R1 to R4.

In FIGS. 4 and 5, reference numeral 110a denotes an area covered in the Z-direction with the XY surface of the magnetic field collecting body 110 positioned at one end in the Z-direction, and reference numerals 124a and 125a respectively denote areas covered in the Z-direction with the overhung parts 124 and 125 of the magnetic field collecting body 120. The side surface 103 of the sensor chip 100 is covered with the protruding part 122 of the magnetic field collecting body 120 in the X-direction, and the side surface 104 of the sensor chip 100 is covered with the protruding part 123 of the magnetic field collecting body 120 in the X-direction. The back surface 102 of the sensor chip 100 is covered with the main body part 121 of the magnetic field collecting body 120.

The areas 110a, 124a, and 125a respectively overlap the magnetic layers M1 to M3. Thus, the magnetic layer M1 is covered with the magnetic field collecting body 110 in the Z-direction, the magnetic layer M2 is covered with the overhung part 124 of the magnetic field collecting body 120 in the Z-direction, and the magnetic layer M3 is covered with the overhung part 125 of the magnetic field collecting body 120 in the Z-direction. Then, a magnetic field in the Z-direction (magnetic field to be detected) is collected by the magnetic field collecting body 110 and applied to the magnetic layer M1 through the magnetic field collecting body 110. The magnetic field thus applied to the magnetic layer M1 is curved in the positive and negative X-directions in the magnetic layer M1. Magnetic flux components curved in the positive X-direction in the magnetic layer M1 are supplied to the magnetic layer M2 through the gaps G1 and G3 and then flow to the overhung part 124, protruding part 122, and main body part 121 of the magnetic field collecting body 120. At this time, a part of the magnetic flux that passes through the gaps G1 and G3 in the positive X-direction is applied to the magnetosensitive elements R1 and R3. On the other hand, magnetic flux components curved in the negative X-direction in the magnetic layer M1 are supplied to the magnetic layer M3 through the gaps G2 and G4 and then flow to the overhung part 125, protruding part 123, and main body part 121 of the magnetic field collecting body 120. At this time, a part of the magnetic flux that passes through the gaps G2 and G4 in the negative X-direction is applied to the magnetosensitive elements R2 and R4.

The magnetic field collecting body 120 need not necessarily have the overhung parts 124 and 125; however, covering the magnetic layers M2 and M3 respectively with the overhung parts 124 and 125 makes it possible to significantly reduce a magnetic resistance between the magnetic field collecting bodies 110 and 120. Further, even when the overhung parts 124 and 125 are absent, it is possible to reduce the magnetic resistance between the magnetic field collecting bodies 110 and 120 by covering the side surfaces 103 and 104 of the sensor chip 100 respectively with the protruding parts 122 and 123. Furthermore, it is possible to efficiently apply a magnetic field in the Z-direction (magnetic field to be detected) to the magnetosensitive elements R1 to R4 by covering the back surface 102 of the sensor chip 100 with the main body part 121 of the magnetic field collecting body 120.

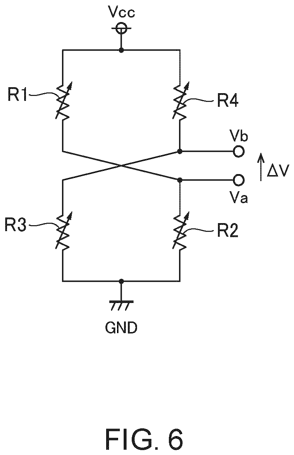

FIG. 6 is a circuit diagram for explaining the connection relationship between the magnetosensitive elements R1 to R4.

As illustrated in FIG. 6, the magnetosensitive elements R1 to R4 are bridge-connected between a power supply Vcc and a ground GND. That is, the magnetosensitive elements R1 and R2 are connected in series between the power supply Vcc and the ground GND, and the magnetosensitive elements R4 and R3 are connected in series between the power supply Vcc and the ground GND. A potential difference between a potential Va appearing at a node between the magnetosensitive elements R1 and R2 and a potential Vb appearing at a node between the magnetosensitive elements R4 and R3 is used as an output signal ΔV (= Va - Vb). As described above, the magnetosensitive elements R1 to R4 constitute a differential bridge circuit, and a change in the electrical resistance of the magnetosensitive elements R1 to R4 according to a magnetic flux density appears as the level of the output signal ΔV.

As illustrated in FIG. 1, a modulation circuit 130 is connected to the excitation coil C1 wound around the magnetic field collecting body 110. The modulation circuit 130 supplies an excitation current i1 having a predetermined frequency to the excitation coil C1 to thereby apply an excitation magnetic field to the magnetosensitive elements R1 to R4 through the magnetic field collecting body 110. When the excitation current i1 is made to flow through the excitation coil C1, the magnetosensitive elements R1 to R4 are saturated at least at a timing when the excitation current i1 becomes maximum. The excitation current i1 has a predetermined frequency, and thus the magnetosensitive elements R1 to R4 are periodically saturated.

That is, in a period during which the excitation coil C1 is not excited, the magnetosensitive elements R1 to R4 can detect a magnetic field to be detected, and the output signal ΔV according to the strength of the magnetic field to be detected appears. On the other hand, in a period during which the excitation coil C1 is excited, the magnetosensitive elements R1 to R4 are magnetically saturated and thus cannot detect the magnetic field to be detected, with the result that the output signal ΔV becomes zero. The output signal ΔV output from the sensor chip 100 is modulated by the frequency of the excitation current i1 supplied from the modulation circuit 130 to the excitation coil C1, so that 1/f noise is significantly reduced.

The maximum value of the excitation current i1 supplied from the modulation circuit 130 to the excitation coil C1 is less than the amount of current that magnetically saturates the magnetic field collecting body 110. Therefore, even when the excitation current i1 having a predetermined frequency is supplied from the modulation circuit 130 to the excitation coil C1, the magnetic field collecting body 110 is not magnetically saturated. This reduces the amount of excitation current i1 to be supplied from the modulation circuit 130, whereby it is possible not only to reduce current consumption but also to suppress heat generation by the excitation current. Thus, the magnetic field collecting body 110 is not magnetically saturated even when the excitation current i1 is supplied to the excitation coil C1, so that the magnetic field to be detected is collected by the magnetic field collecting body 110 even at a timing when the excitation current i1 becomes maximum and applied to the magnetosensitive elements R1 to R4. However, since the magnetosensitive elements R1 to R4 are magnetically saturated at this timing, the sensitivities of the magnetosensitive elements R1 to R4 are zero.

In order to periodically saturate the magnetosensitive elements R1 to R4 without magnetically saturating the magnetic field collecting body 110, magnetic field collection efficiency is designed such that the magnetic flux density of a magnetic field flowing through the magnetic field collecting body 110 is higher than the magnetic flux density of magnetic fields flowing through the magnetosensitive elements R1 to R4. That is, a magnetic field collection efficiency G defined by B/A (B = magnetic flux density of magnetic fields flowing through the magnetosensitive elements R1 to R4, and A = magnetic flux density of a magnetic field flowing through the magnetic collecting body 110) is designed to exceed 1, and the amount of the excitation current i1 supplied from the modulation circuit 130 to the excitation coil C1 is adjusted so as to make the magnetic flux density A equal to or lower than the saturation magnetic field of the magnetic field collecting body 110 and to make the magnetic flux density B exceed the saturation magnetic field of the magnetosensitive elements R1 to R4. The saturation magnetic field refers to a magnetic field where magnetization of a ferromagnetic body is saturated.

When the magnetic field collection efficiency G exceeds 1, the saturation magnetic field of the magnetic field collecting body 110 may be lower than the saturation magnetic field of the magnetosensitive elements R1 to R4. For example, assuming that the saturation magnetic field of the magnetic field collecting body 110 is a and that the saturation magnetic field of the magnetosensitive elements R1 to R4 is b, it is possible to periodically magnetically saturate the magnetosensitive elements R1 to R4 without magnetically saturating the magnetic field collecting body 110 when b/a < G is satisfied even though a is lower than b. For example, when the saturation magnetic field a of the magnetic field collecting body 110 is about 1.5 Oe, and the saturation magnetic field b of the magnetosensitive elements R1 to R4 is about 1000 Oe, the magnetic field collection efficiency G may be designed to be about 67 or more. Actually, when a ferrite block is used as the material of the magnetic field collecting bodies 110 and 120, and a permalloy thin film is used as the material of the magnetic layers M1 to M3, the magnetic field collection efficiency G can be designed to be 1200 to 2000. Thus, even when the saturation magnetic fields of the magnetic field collecting body 110 and magnetosensitive elements R1 to R4 are above values, it is possible to periodically magnetically saturate the magnetosensitive elements R1 to R4 without magnetically saturating the magnetic field collecting body 110.

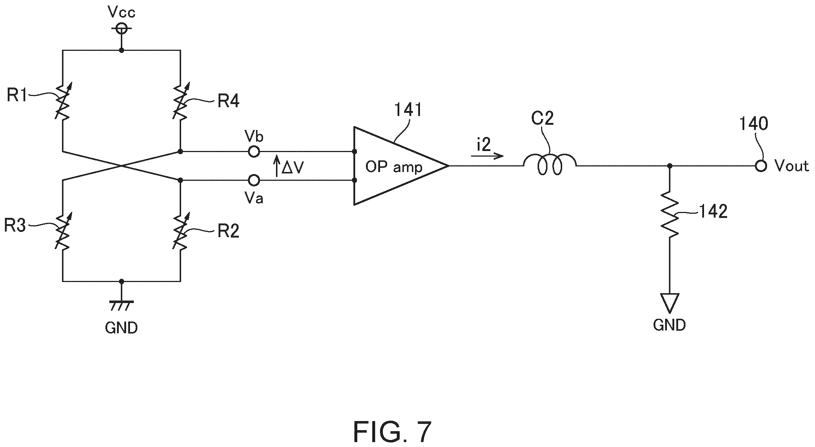

FIG. 7 is a circuit diagram of a closed loop circuit including the magnetosensitive elements R1 to R4.

The closed loop circuit illustrated in FIG. 7 includes an operation amplifier 141 receiving the output signal ΔV, a compensation coil C2 connected between the output node of the operation amplifier 141 and an output terminal 140, and a resistor 142 connected between the output terminal 140 and a ground GND. The compensation coil C2 is integrated in the sensor chip 100 as illustrated in FIG. 2. When a compensation current i2 output from the operation amplifier 141 flows through the compensation coil C2, a canceling magnetic field is generated. Thus, when the output signal ΔV according to the magnetic flux density of the magnetic field to be detected is generated, corresponding compensation current i2 flows through the compensation coil C2 to generate a canceling magnetic field in an opposite direction, whereby the magnetic field to be detected is cancelled. Then, the compensation current i2 is subjected to current-voltage conversion using the resistor 142 to generate an output signal Vout, whereby the strength of the magnetic field to be detected can be detected. Using the thus configured closed loop circuit enables highly accurate detection of magnetic fields collected through the magnetic field collecting bodies 110 and 120.

When such a closed loop circuit is used, the maximum value of the excitation magnetic field that the excitation coil C1 applies to the magnetosensitive elements R1 to R4 is designed to be larger than the maximum value of the canceling magnetic field that the compensation coil C2 applies to the magnetosensitive elements R1 to R4, whereby it is possible to periodically magnetically saturate the magnetosensitive elements R1 to R4 while preventing the excitation magnetic field from being completely cancelled by the canceling magnetic field.

The excitation current i1 generated by the modulation circuit 130 may be an alternating current having a sine waveform or a pulse-like direct current having a predetermined frequency. When a pulse-like direct current having a predetermined frequency is used as the excitation current i1, a state where the current value becomes zero continues for a certain period of time in one cycle of the excitation current i1, allowing a sufficient period of time during which the output signal Vout can be observed to be ensured. In this case, by designing such that a time period during which the current value becomes zero (duty ratio) exists 25% or more of one period of the excitation current i1, it is possible to provide a more sufficient time period during which the output signal Vout can be observed.

As described above, the magnetic sensor 1 according to the present embodiment has the magnetic field collecting bodies 110 and 120 for collecting a weak magnetic field to be detected in the sensor chip 100 and the excitation coil C1 wound around the magnetic field collecting body 110. Thus, by making the excitation current i1 having a predetermined frequency flow through the excitation coil C1 using the modulation circuit 130, the detection signal (ΔV or Vout) obtained from the magnetosensitive elements R1 to R4 can be modulated. As a result, even when the frequency of a weak magnetic field to be detected is low, 1/f noise can be reduced significantly. In addition, the excitation magnetic field generated by the excitation coil C1 is of a level that periodically magnetically saturates the magnetosensitive elements R1 to R4 without magnetically saturating the magnetic field collecting body 110, which reduces current consumption. When a common magnetic material is used, the saturation magnetic field of the magnetic field collecting body 110 is lower than the saturation magnetic field of the magnetosensitive elements R1 to R4; however, by designing such that the magnetic field collection efficiency G becomes large, it is possible to periodically magnetically saturate the magnetosensitive elements R1 to R4 without magnetically saturating the magnetic field collecting body 110.

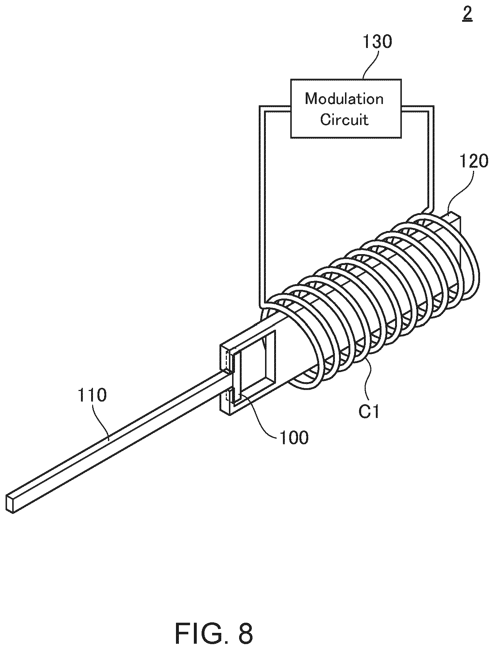

FIG. 8 is a schematic perspective view illustrating the outer appearance of a magnetic sensor 2 according to a second embodiment of the present disclosure.

As illustrated in FIG. 8, the magnetic sensor 2 according to the second embodiment differs from the magnetic sensor 1 according to the first embodiment in that the excitation coil C1 is wound around the magnetic field collecting body 120. Other basic configurations are the same as those of the magnetic sensor 1 according to the first embodiment, so the same reference numerals are given to the same elements, and overlapping description will be omitted. As exemplified by the magnetic sensor 2 according to the second embodiment, the excitation coil C1 may be wound around the magnetic field collecting body 120 instead of being wound around the collecting body 110.

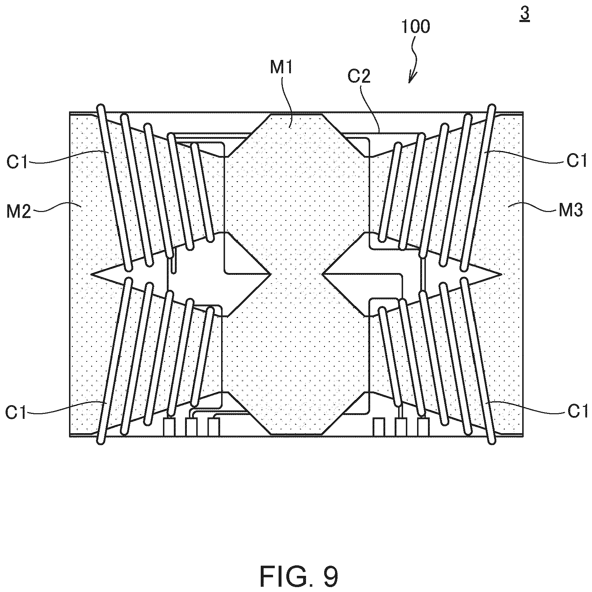

FIG. 9 is a schematic plan view illustrating the configuration of the main part of a magnetic sensor 3 according to a third embodiment of the present disclosure, where the collecting bodies 110 and 120 are omitted.

As illustrated in FIG. 9, the magnetic sensor 3 according to the third embodiment differs from the magnetic sensor 1 according to the first embodiment in that the excitation coil C1 is integrated in the sensor chip 100 and wound around the magnetic layers M2 and M3. Other basic configurations are the same as those of the magnetic sensor 1 according to the first embodiment, so the same reference numerals are given to the same elements, and overlapping description will be omitted. As exemplified by the magnetic sensor 3 according to the third embodiment, the excitation coil C1 may be wound around the magnetic layers M2 and M3 on the sensor chip 100 instead of being wound around the collecting body 110.

While some embodiments of the technology according to the present disclosure have been described, the technology according to the present disclosure is not limited to the above embodiments, and various modifications may be made within the scope of the present disclosure, and all such modifications are included in the technology according to the present disclosure.

The technology according to the present disclosure includes the following configuration examples, but not limited thereto.

A magnetic sensor according to an aspect of the present disclosure includes: a sensor chip having a magnetosensitive element; a magnetic field collecting body for collecting a magnetic field to the magnetosensitive element; an excitation coil wound around the magnetic field collecting body; and a modulation circuit that supplies an excitation current having a predetermined frequency to the excitation coil so as to periodically magnetically saturate the magnetosensitive element without magnetically saturating the magnetic field collecting body. With this configuration, it is possible to periodically magnetically saturate the magnetosensitive element with less amount of current.

In the above magnetic sensor, the magnetic field collecting body may be lower than the magnetosensitive element in terms of saturation magnetic field. This allows a common magnetic material such as ferrite to be used as the material of the magnetic field collecting body.

The above magnetic sensor may further include a compensation coil integrated in the sensor chip and acting to cancel a magnetic field to be applied to the magnetosensitive element. This allows closed loop control to be performed. In this case, the maximum value of an excitation magnetic field that the excitation coil applies to the magnetosensitive element may be larger than the maximum value of a canceling magnetic field that the compensation coil applies to the magnetosensitive element. This prevents the excitation magnetic field to be applied to the magnetosensitive element from being cancelled by the compensation coil.

In the above magnetic sensor, a state where a current value of the excitation current becomes zero may continue for a certain period of time in one cycle of the excitation current. This allows a sufficient period of time during which an output signal can be observed to be ensured. In this case, a time period during which the current value becomes zero exists 25% or more of one cycle of the excitation current. This can provide a more sufficient time period during which the output signal can be observed.

## Claims

1. A magnetic sensor comprising:
a sensor chip having a magnetosensitive element;
a magnetic field collecting body for collecting a magnetic field to the magnetosensitive element;
an excitation coil wound around the magnetic field collecting body; and
a modulation circuit that supplies an excitation current having a predetermined frequency to the excitation coil so as to periodically magnetically saturate the magnetosensitive element without magnetically saturating the magnetic field collecting body.

2. The magnetic sensor as claimed in claim 1, wherein the magnetic field collecting body is lower than the magnetosensitive element in terms of saturation magnetic field.

3. The magnetic sensor as claimed in claim 1 or 2, further comprising a compensation coil integrated in the sensor chip and acting to cancel a magnetic field to be applied to the magnetosensitive element.

4. The magnetic sensor as claimed in claim 3, wherein a maximum value of an excitation magnetic field that the excitation coil applies to the magnetosensitive element is larger than a maximum value of a canceling magnetic field that the compensation coil applies to the magnetosensitive element.

5. The magnetic sensor as claimed in any one of claims 1 to 4, wherein a state where a current value of the excitation current becomes zero continues for a certain period of time in one cycle of the excitation current.

6. The magnetic sensor as claimed in claim 5, wherein a time period during which the current value becomes zero exists 25% or more of one cycle of the excitation current.
